# EUROPÄISCHE PATENTANMELDUNG

(11) **EP 1 710 605 A1**
(43) Veröffentlichungstag der Anmeldung: **11.10.2006**
(21) Anmeldenummer: 06006652.9
(22) Anmeldetag: 30.03.2006
(51) Int. Cl.: G02B 6/132, G02B 6/136, G02B 6/13, G02B 6/122, G02B 6/43

(54) **Optische Leiterplatte und Verfahren zu ihrer Herstellung**

(30) Priorität: 05.04.2005 DE 102005016435
(71) Anmelder: Würth Elektronik GmbH, 74585 Rot am See (DE)
(72) Erfinder: Kostelnik, Jan, 74592 Kirchberg (DE)
(74) Vertreter: Patentanwälte Ruff, Wilhelm, Beier, Dauster & Partner

(57) **Zusammenfassung**

Es wird eine optische Leiterplatte und ein Verfahren zu ihrer Herstellung vorgeschlagenen, wobei auf einer Trägerplatte (1) drei Schichten (2,3,4) aus optisch leitendem Material aufgebracht werden. Der Brechungsindex der ersten (2) und dritten (4) Schicht ist geringfügig kleiner als der Brechungsindex der später den Wellenleiterkern bildenden mittleren Schicht (3). Der zunächst schichtförmige Aufbau der Materialien und die anschließende Strukturierung mittels Trennprozess (Einschneiden von Gräben (5) bis in die erste Schicht (2) hinein) ermöglicht es, die einzelnen Schichten sehr homogen aufeinander aufzubringen. Dadurch sind bereits zwei optisch relevante Seiten sehr genau definiert. Die nach der Beschichtung durchgeführte Strukturierung erfolgt vorteilhafterweise mit Hilfe eines Lasers (auch Fräsen/Schneiden möglich). Dabei werden die zwei weiteren zu definierenden Seiten des Wellenleiters vorbereitet. Durch einen anschließenden Füllprozess der Gräben (5) werden die zwei Seiten mit dem gleichen optischen Material gefüllt, aus dem die Oberschicht und die Unterschicht besteht. Dadurch ergibt sich ein vollständiger Wellenleiterkern.

## Beschreibung

Die Erfindung betrifft eine mehrlagige Leiterplatte mit einer optischen Leitung sowie ein Verfahren zum Herstellen einer solchen Leiterplatte.

Leiterplatten, bei denen elektronische und optoelektronische Bauteile zusammengefasst sind, sind bekannt (US-5249245). Leiterplatten dieser Art enthalten optische Leiter, die dazu denen, Lichtsignale durch die Leiterplatte hindurch zu leiten.

Bei einer weiteren mehrlagigen Leiterplatte (DE 10061831) wird eine Lage aus optisch leitendem Material mit einer Trägerplatte verbunden.

Weiterhin ist eine Leiterplatte für elektrische und optische Signale sowie ein Verfahren zu deren Herstellung bekannt (EP 1155348).

Natürlich sind auch einzelne Glasfasern als optische Leiter bekannt.

Der Erfindung liegt die Aufgabe zu Grunde, eine Möglichkeit zu schaffen, Leiterplatten herzustellen, mit denen eine EMV-sichere Übertragung von hoch bitratigen Signalen auf Baugruppenträgerebene möglich ist. Darüber hinaus soll es auch möglich sein, die Leiterplatte für designoptische Funktionen, wie Leucht-/Markierungs- und Schriftdarstellung einzusetzen.

Zur Lösung dieser Aufgabe schlägt die Erfindung ein Verfahren mit den Merkmalen des Anspruchs 1 sowie eine Leiterplatte mit den Merkmalen des Anspruchs 10 vor. Weiterbildungen der Erfindung sind Gegenstand der jeweiligen abhängigen Patentansprüche.

Die Leiterplatte wird folgendermaßen hergestellt. Ausgehend von einer Trägerplatte wird in einem kontinuierlichen Prozess, wie er bei der Leiterplattentechnik schon bekannt ist, auf die Trägerplatte eine optisch leitende Schicht aus einem ersten Material aufgebracht. Anschließend wird auf diese Schicht eine zweite Schicht aus einem optisch leitenden Material mit einem größeren Brechungsindex aufgebracht. Dann wird wieder eine Schicht aus einem optisch leitenden Material mit einem kleineren Brechungsindex aufgebracht. Die optisch relevante Trennschicht zwischen den einzelnen Schichten ist damit schon gegenüber äußeren Einflüssen geschützt. Diese drei Schichten sind nach Herstellung genau definiert. Die zwei bereits abgedeckten Seiten des herzustellenden Wellenleiters können dadurch weder durch Staub noch durch Laserablation beschädigt werden. Nach Herstellung des Schichtaufbaus aus drei optisch leitenden Schichten werden von der Oberseite, also von der der Trägerplatte abgewandten Seite des Aufbaus, her zwei Gräben eingeschnitten, die bis in die Tiefe der ersten direkt der Trägerplatte benachbarten Schicht reichen. Zwischen diesen beiden Gräben ist also ein dreilagiger Aufbau vorhanden. In die Gräben wird nun wieder ein Material mit einem Brechungsindex eingefüllt, der kleiner ist als der Brechungsindex der mittleren Schicht. Als Ergebnis ist ein Kanal in der mittleren Schicht gebildet, der aus einem optisch leitendem Material besteht, das allseits von optisch leitendem Material mit einem kleineren Brechungsindex umgeben ist. An allen Flächen tritt eine Totalreflexion auf.

Der Auftrag der Schichten ist hoch automatisierbar und leicht zu kontrollieren. Er kann mit einem beliebigen Verfahren durchgeführt werden, beispielsweise Schleudern, Sprühen, Gießen oder Rakeln.

In Weiterbildung der Erfindung kann vorgesehen sein, das als Material für die erste und dritte Schicht und auch als Material für das Füllen der beiden Gräben ein Material mit identischem Brechungsindex verwendet wird, vorzugsweise für die beiden Schichten und die Gräben das gleiche Material.

Die Gräben können beispielsweise mit einem Schneidmesser geschnitten werden, oder auch mit einem Laser oder Fräser. Außerdem ist es möglich, sie nasschemisch zu erzeugen.

Erfindungsgemäß kann vorgesehen sein, dass die Oberseite der dreilagigen Schicht vor oder nach dem Füllen der Gräben mit einer Deckschicht versehen wird. Wenn die Deckschicht vor dem Füllen der Gräben aufgebracht wird, kann es sinnvoll sein, anschließend nochmals eine Deckschicht aufzubringen.

Falls in dem Schichtaufbau zwei optische Wellenleiter nebeneinander hergestellt werden sollen, kann zu ihrer Trennung ein einzelner Graben dienen, der damit einen Teil des Mantels für beide optische Wellenleiter bildet.

Die von der Erfindung vorgeschlagene Leiterplatte enthält mindestens drei aufeinander aufgebrachte optisch leitende Schichten, sowie mindestens einen in der mittleren der drei optischen Schichten ausgebildeten Wellenleiter, der von einem Mantel aus optisch leitendem Material mit kleinerem Brechungsindex umgeben ist.

Die drei Schichten können auf der Trägerplatte, die zur Herstellung des dreilagigen Aufbaus benutzt wurde, verbleiben. Es ist aber auch möglich, dass die Trägerplatte nur eine temporäre tragende Funktion besitzt und nur während der Herstellung benutzt wird.

Es kann dabei in Weiterbildung vorgesehen sein, dass zwei gegenüberliegende Seiten des Wellenleiters von der Trennfläche zu der ersten und dritten Schicht gebildet werden.

Die bei dem senkrecht zur Trägerplatte und zu den Schichten verlaufenden Seiten des Wellenleiters können dabei vorzugsweise von Verbindungen zwischen der ersten und dritten Schicht gebildet sein.

Vorzugsweise kann vorgesehen sein, dass die erste und dritte Schicht und die Verbindung zwischen diesen aus einem optisch leitenden Material mit gleichem Brechungsindex gebildet werden.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung einer bevorzugten Ausführungsform der Erfindung sowie anhand der Zeichnung. Hierbei zeigen:

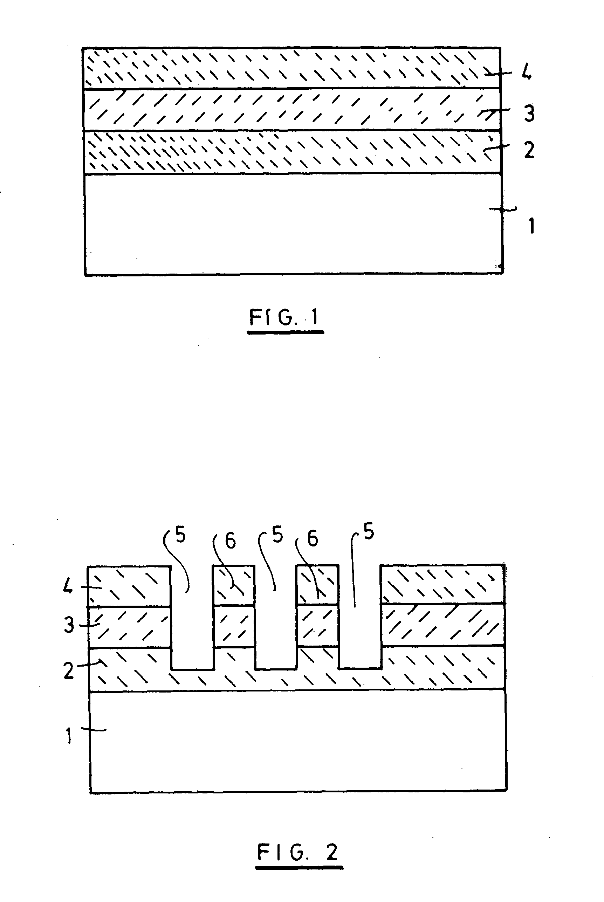

- Figur 1: den Aufbau der von der Erfindung vorgeschlagenen Leiterplatte nach Aufbringen der drei optisch leitenden Schichten;
- Figur 2: den Zustand nach Einbringen von drei Gräben;
- Figur 3: den Zustand nach Füllen der Gräben;
- Figur 4: das Ergebnis des Herstellungsvorgangs.
- Figur 5: eine der Figur 4 entsprechende Darstellung bei einer weiteren Ausführungsform.

Auf eine im Querschnitt zu sehende Trägerplatte 1 wird in einem ersten Verfahrensschritt eine erste Schicht 2 aus optisch leitendem Material mit einem bestimmten Brechungsindex aufgebracht. Auf diese Schicht 2 wird eine zweite Schicht 3 aus einem optisch leitenden Material mit einem größeren Brechungsindex aufgebracht. Anschließend wird wiederum eine Schicht 4 aus optisch leitendem Material mit dem gleichen Brechungsindex wie die Schicht 2 aufgebracht. Diese Herstellung des Schichtaufbaus kann in einem beliebigen bekannten Verfahren erfolgen. Die optischen Schichten können beispielsweise teilweise oder vollständig aus Glas oder anderen optisch leitenden Materialien bestehen oder miteinander kombiniert sein.

Die Trennungsflächen zwischen den einzelnen Schichten sind nach Herstellung des Schichtaufbaus schon gegenüber äußeren Einflüssen geschützt. Die Herstellung der Schichten kann mit großer Präzision erfolgen.

Anschließend werden in dem dargestellten Beispiel drei Gräben 5 von der Oberseite 6 des Schichtaufbaus aus in den Schichtaufbau eingebracht. Dies kann durch Schneiden mit einem Schneidmesser oder mit Hilfe eines Lasers erfolgen. Die Gräben werden so tief gebildet, dass sie bis etwa in die Mitte der ersten Schicht 2 reichen. Sie können auch tiefer reichen.

Zwischen je zwei Gräben 5 ist dadurch eine Scheibe 7 gebildet, die etwa so dick ist wie die Dicke der Schichten 2 bis 4. In dem dargestellten Beispiel sind drei Gräben 5 eingeschnitten worden, so dass zwischen den drei Kerben 5 zwei derartige Schreiben 7 gebildet sind.

Bei dem Schneidvorgang werden die Trennflächen zwischen den einzelnen Schichten nicht beschädigt.

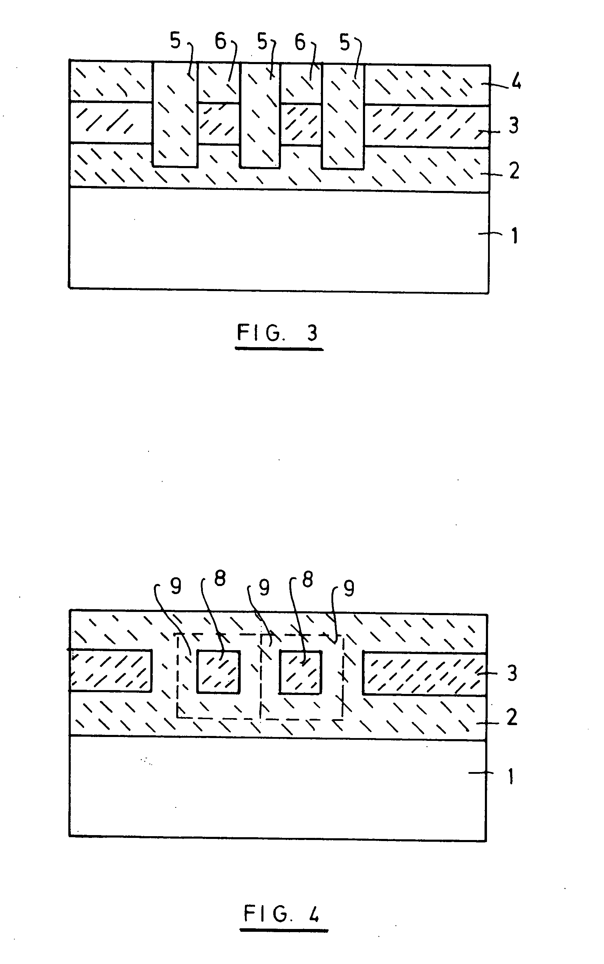

In einem weiteren Verfahrensschritt, siehe Figur 3, werden jetzt die Gräben 5 mit dem Material der ersten und dritten Schicht 2, 4 gefüllt. In Figur 3 sind die Trennflächen zwischen den Gräben 5 und der ersten und dritten Schicht 2, 4 noch dargestellt, obwohl diese Trennflächen nach dem Einfüllen des Materials verschwinden. Dies ist in Figur 4 dargestellt. Es sind jetzt zwei Wellenleiterkerne 8 gebildet, die allseits von einem homogenen Mantel 9 aus Material eines kleineren Brechungsindex umgeben sind. Obwohl auch das umliegende Material optisch leitend ist, werden für die optische Signalleitung nur die Kerne 8 verwendet.

Es ist möglich, anschließend noch eine Deckschicht aufzubringen, die auch einen mechanischen Schutz verwirklichen soll. Natürlich sind auch Aufbauten aus mehr als drei optisch leitenden Schichten möglich, auch die Anordnung von Wellenleiterkernen in einer dann anderen Schicht.

Das gerade beschriebene Verfahren zur Herstellung einer Leiterplatte kann auf einem elektrisch optischen Halbzeug erfolgen oder als einzelne optische vorgefertigte und in eine Leiterplatte integrierbare Lösung realisiert werden.

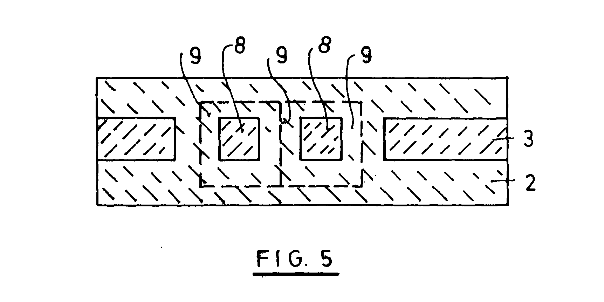

Figur 5 zeigt die Möglichkeit, dass nach der Herstellung des beispielsweise dreilagigen Aufbaus dieser Aufbau von der Trägerplatte gelöst wird und ohne die Trägerplatte als fertiges Element verwendet wird. Die Trägerplatte dient also in diesem Fall nur als temporärer Träger, um dem Aufbau die anfängliche Stabilität zu geben.

## Patentansprüche

1. Verfahren zum Herstellen einer Leiterplatte mit optischer Leitung, mit folgenden Verfahrensschritten:
1.1 auf eine Trägerplatte (1) wird eine erste Schicht (2) aus einem optisch leitenden Material aufgebracht,
1.2 auf die erste Schicht (2) wird eine zweite Schicht (3) aus einem optisch leitenden Material mit einem größeren Brechungsindex als dem der ersten Schicht (2) aufgebracht,
1.3 auf die zweite Schicht (3) wird eine dritte Schicht (4) aus einem optisch leitenden Material mit einem Brechungsindex aufgebracht, der kleiner ist als der der zweiten Schicht (3),
1.4 in die **dadurch** gebildete dreilagige Schicht werden von der Oberseite der dritten Schicht (4) ausgehend zwei Gräben (5) mit gegenseitigem Abstand bis in die erste Schicht (2) hinein eingebracht,
1.5 die beiden Gräben (5) werden mit einem Material mit einem Brechungsindex kleiner als dem der zweiten Schicht (3) aufgefüllt.

2. Verfahren nach Anspruch 1, bei dem für die erste (2) und dritte Schicht (4) und das Material der Gräben (5) das gleiche Material verwendet wird.

3. Verfahren nach Anspruch 1 oder 2, bei dem mindestens ein Graben (5), vorzugsweise alle Gräben (5) mit einem Schneidmesser geschnitten werden.

4. Verfahren nach Anspruch 1 oder 2, bei dem mindestens ein Graben (5), vorzugsweise alle Gräben (5) mit einem Laser geschnitten werden.

5. Verfahren nach einem der vorhergehenden Ansprüche, bei dem mindestens ein Graben (5), vorzugsweise alle Gräben (5), mit einem Fräser geschnitten werden.

6. Verfahren nach einem der vorhergehenden Ansprüche, bei dem mindestens ein Graben (5), vorzugsweise alle Gräben (5), nasschemisch erzeugt werden.

7. Verfahren nach einem der vorhergehenden Ansprüche, bei dem nach oder vor dem Füllen der Gräben (5) die Oberseite der dritten Schicht (4) mit einer Deckschicht versehen wird.

8. Verfahren nach einem der vorhergehenden Ansprüche, bei dem zur Herstellung zweier benachbarter Wellenleiter ein beiden Wellenleitern gemeinsamer Graben (5) eingeschnitten und gefüllt wird.

9. Verfahren nach einem der vorhergehenden Ansprüche, bei dem acht nach Fertigstellung des dreilagigen Aufbaus die Trägerplatte (1) entfernt wird.

10. Leiterplatte, mit
10.1 mindestens drei aufeinander aufgebrachten optisch leitenden Schichten (2, 3, 4) sowie mit
10.2 mindestens einem optischen Wellenleiter (8), der
10.2.1 in der mittleren (3) der drei optischen Schichten (2, 3, 4) ausgebildet und
10.2.2 von einem Mantel (9) aus optisch leitendem Material mit kleinerem Brechungsindex umgeben ist.

11. Leiterplatte nach Anspruch 10, bei der zwei gegenüberliegende Seiten des Wellenleiters (8) von der Trennfläche zu der ersten (2) und der dritten Schicht (4) gebildet sind.

12. Leiterplatte nach Anspruch 10 oder 11, bei der die beiden senkrecht zur Trägerplatte (1) verlaufenden Seiten des Wellenleiters (8) von Verbindungen zwischen der ersten (2) und der dritten Schicht (4) gebildet sind.

13. Leiterplatte nach Anspruch 12, bei der die erste (2) und dritte Schicht (4) und die Verbindungen zwischen diesen aus einem optisch leitenden Material mit dem gleichen Brechungsindex gebildet sind.

14. Leiterplatte nach einem der Ansprüche 10 bis 13, bei dem die mindestens drei aufeinander aufgebrachten optisch leitenden Schichten (2, 3, 4) mit dem mindestens einen optischen Wellenleiter (8) auf einer Trägerplatte (1) aufgebracht sind.
